# EUROPÄISCHE PATENTSCHRIFT

(11) **EP 1 192 660 B1**
(45) Veröffentlichungstag und Bekanntmachung des Hinweises auf die Patenterteilung: **18.11.2009**
(21) Anmeldenummer: 00949091.3
(22) Anmeldetag: 13.06.2000
(51) Int. Cl.: H01L 27/146

(54) **HALBLEITERSENSOR MIT EINER PIXELSTRUKTUR SOWIE VERWENDUNG DES SENSORS IN EINEM VAKUUMSYSTEM**
SEMICONDUCTOR SENSOR, COMPRISING A PIXEL STRUCTURE AND THE USE OF SAID SENSOR IN A VACUUM SYSTEM
CAPTEUR A SEMI-CONDUCTEUR POURVU D'UNE STRUCTURE A PIXELS, ET UTILISATION DE CE CAPTEUR DANS UN SYSTEME A VIDE

(30) Priorität: 17.06.1999 DE 19927694
(43) Veröffentlichungstag der Anmeldung: 03.04.2002
(73) Patentinhaber: Rheinmetall Defence Electronics GmbH, 28309 Bremen (DE)
(72) Erfinder: FINK, Lutz, 21698 Issendorf (DE)
(74) Vertreter: Thul, Hermann
(86) Internationale Anmeldenummer: PCT/DE2000/001934
(87) Internationale Veröffentlichungsnummer: WO 2000/079594

(56) Entgegenhaltungen:
- EP-A- 0 588 397
- US-A- 3 902 095
- US-A- 5 311 038
- US-A- 5 365 056

## Beschreibung

Die Erfindung betrifft einen Halbleitersensor mit einer Pixelstruktur, wobei zu jedem Pixel eine Kapazität ausgebildet ist, die Ladung speichert und in Spannung konvertiert, die bedarfsweise auslesbar ist, und die Pixelstruktur im wesentlichen vollständig mit einer leitfähigen Schicht abgedeckt ist. Ferner betrifft die Erfindung die Verwendung des Sensors angeordnet in einem Vakuumsystem (IC) mit Photokathode. Der Halbleitersensor eignet sich insbesondere zur Bilderfassung in optoelektronischen Anordnungen.

Optoelektronische Bildwandler in Halbleitertechnik sind bekannt. Beim sogenannten CCD-Bauelement werden durch die auf die Sensorfläche einfallenden Photonen Elektronen aus der Gitterstruktur herausgelöst (Photoeffekt), die dann am Konversionsort in sogenannten Pixelzellen gespeichert und nachfolgend nach verschiedenen Methoden ausgelesen werden. Darüber hinaus sind Aktiv-Pixelsensoren (APS) bekannt, bei denen jedes Pixel mit mindestens einem Transistor verschmolzen ist, der die Pixelinformation konvertiert oder entkoppelt und auf Abfrage direkt zur Auslesung gibt.

Nachteilig ist jedoch, daß die bekannten Bildwandler empfindlich gegen auf die Sensorfläche auftreffende Elektronen reagieren. Die kinetische Energie der Elektronen beeinflußt die kristalline Halbleiterstruktur, so daß das System beim Betrieb aufgebrochen wird und Pixeldefekte entstehen, die sich z. B. durch Dunkelströme zeigen. So ist es nicht sinnvoll, ein derartiges Halbleiterelement in einer Bildverstärkerröhre zu integrieren, um die Information beispielsweise direkt in ein Videosignal zu konvertieren.

Eine von einer leitfähigen Schicht abgedeckte Pixel-struktur ist aus der EP 0 588 397 A2 in Form eines Röntgenbilddetektors bekannt. Die leitfähige Deckschicht dient als Vorspannungselektrode, um Ladungsträger, die in einer Photoleiterschicht erzeugt werden, unter dem Einfluß eines mittels dieser Elektrode erzeugten elektrischen Feldes zu den einzelnen Sammelelektroden der Pixel zu lenken. Ähnliche Halbleiterbildsensoren sind beispielsweise aus der EP 0 444 702 A1, dem Patent abstract of Japan JP 06310699 A, 1994, JPO, der US 4,789,888 und der US 5,311,038 in Form von licht- und/oder röntgenstrahlenempflindlichen Sensoren bekannt. Aus den beiden letztgenannten Schriften ist es außerdem bekannt, Zwischenräume abzudecken, um dort den unerwünschten Einfluß einfallenden Lichts zu verhindern.

Darüber hinaus ist aus dem Patent abstracts of Japan: JP 2-94566 A E-944, 1990, Vol. 14/No. 292 ein Halbleitersensor mit Pixelelektroden mit einer weiteren, wenigstens die Zwischenräume abdeckenden Schicht bekannt. Es handelt sich jedoch um einen optischen Halbleitersensor, bei dem Mehrfachreflexionen an der Innenseite der optischen Abdeckschicht durch einen Reflexionen vermeidenden Film verringert oder beseitigt werden.

Aus der US 3,902,095 ist ein Elektronenstrahlhalbleiterverstärker mit abgeschirmten Diodengrenzschichten bekannt, der als Elektronenstrahlhalbleiterröhre beispielsweise als Sendeverstärker, Schaltröhre oder zur Ansteuerung für andere Hochspannungsverstärkerröhren, wie beispielsweise Wanderfeldröhren für Radarsender ausgebildet ist. Der Halbleiter ist mit einer leitfähigen Abdeckschicht teilweise abgedeckt, wobei die Abschirmung Öffnungen oberhalb eines Abschnittes der Diodengrenzschicht hat. Hier sollen die Elektronen gezielt in den Halbleiter einschlagen, wobei die Abschirmung unerwünschten Elektroneneinschlag in den Randbereichen der Vorrichtung (Diode) verhindert. Damit werden unerwünschte Oberflächen- und Tiefenladungseffekte vermieden. Somit wird die maximale Sperr-Vorspannung erhöht, womit die maximal mögliche Ausgangsleistung derartige Dioden enthaltender Röhren erhöht wird. Die Verwendung von mehreren nebeneinander angeordneten Dioden, hergestellt aus einer Halbleiterschicht, dient zur Effektivitätserhöhung des Verstärkers, wobei insbesondere durch eine Reihenschaltung der Dioden die Gesamtkapazität im Verhältnis zur exponierten Oberfläche verringert werden kann. Die Halbleiterröhre ist jedoch weder für eine bildgebende Detektierung ausgelegt noch geeignet.

Ferner ist aus der DE 42 23 693 A1 ein Röntgenbildverstärker mit einem Vakuumgehäuse, einem Eingangsleuchtschirm, einer Elektronenoptik und einem auf der dem Eingangsleuchtschirm gegenüberliegenden Seite des vakuumgehäuses innerhalb desselben angebrachten Bildsensor bekannt, bei dem die von einer Photokathode ausgehenden Elektronen direkt in einem CCD-Bildwandler in ein Videosignal umgewandelt werden. Dabei ist der Bildsensor mit einem Schichtsystem versehen, das mindestens eine Halbleiterschicht aufweist, die eine Elektronenwandlung bewirkt und aus amorphem Halbleitermaterial besteht. Diese Druckschrift zeigt daher eine gegenständlich anders ausgebildete Lösung der nachfolgenden Aufgabe.

Ausgehend von der EP 0 588 397 A2 ist es Aufgabe der Erfindung, einen Halbleitersensor mit einer Pixelstruktur anzugeben, der Elektronen detektiert und dessen Halbleiterstruktur vor Elektronenbeschuß geschützt ist.

Diese Aufgabe wird mit einem Halbleitersensor gemäß Anspruch 1 gelöst.

Die Abdeckung der Pixeloberfläche mit einer leitfähigen Schicht erlaubt das Einfangen der auftreffenden Elektronen, die als Ladung gespeichert werden und in für Halbleiterbildwandler üblicher Weise in Spannung konvertiert und ausgelesen werden. Dabei wirkt die leitfähige Beschichtung als Elektrode für die auftreffenden Elektronen, wobei die Elektrode Bestandteil einer Kapazität ist und somit der Ladungsspeicherung dient. Das wesentliche dabei ist, daß die an und für sich elektronenempfindliche Pixeloberfläche und die darunterliegenden Halbleiterstrukturen durch die leitfähige Schicht abgeschirmt sind. Die auftreffenden Elektronen werden so als Meßsignal getrennt für das jeweilig getroffene Pixel verarbeitet.

Die auf die Beschichtung auftreffenden Elektronen werden somit pixelorientiert aufgefangen und daran gehindert, in die Halbleiterstruktur einzudringen und dort Dunkelströme, Fehlpixel, Zeilen-/Spaltenausfall oder dergleichen Defekte hervorzurufen.

Da die Oberfläche von Zwischenräumen zwischen den Pixeln mit einer zweiten leitfähigen Schicht abgedeckt ist, wobei die zweite leitende Schicht isoliert von den Pixeloberflächenbeschichtungen angeordnet ist, werden auch die Zwischenräume zwischen den Pixeln vor unerwünscht in die Halbleiterschicht eindringenden Elektronen geschützt. Dabei kann diese isoliert von den Pixeloberflächenbeschichtungen angeordnete zweite Schicht auch durch Anlegen eines Potentials zur Feldveränderung, beispielsweise als Beschleunigungspotential, verwendet werden.

Die Schichten bestehen bevorzugt aus einem leitfähigen, lichtundurchlässigen Material, z. B. Metall. Auftreffende Elektronen werden von dem leitfähigen Material sicher aufgenommen und in die Halbleiterstruktur eingespeist. Etwaig auftreffende Photonen werden durch das lichtundurchlässige Material nicht zur Sensoroberfläche durchgelassen, so daß unerwünschte Nebensignale vermieden werden. Bevorzugt bestehen die Schichten aus Aluminium, da dieses Material leicht aufzubringen ist, eine gute Leitfähigkeit und eine hohe Lichtundurchlässigkeit aufweist.

Je nach Ausbildung des Halbleiters kann die, die Zwischenräume abdeckende zweite leitfähige Schicht, als Kondensatorelektrode verwendet werden. Außerdem kann ein Potential zur Beschleunigung des auftreffenden Elektronenstromes an die zweite leitfähige Schicht angelegt werden.

Wenn die Detektionsoberfläche des Sensors mit einer elektronenverstärkenden Beschichtung versehen ist, wobei Durchgangskanäle zu den Pixeloberflächen vorgesehen sind, wird eine Elektronenvervielfachung unmittelbar vor den Sensoroberflächen erreicht. Als elektronenverstärkendes Material kann beispielsweise Alpha-Silizium verwendet werden. Die in der Beschichtung vorgesehenen Öffnungen erlauben den ungehinderten Durchtritt der Elektronen zur Sensoroberfläche, wobei an den Wandungen in diesen Öffnungen auftreffende Elektronen zu einer Vervielfachung der Elektronen und somit zur Signalverstärkung führen.

Dadurch, daß die elektronenverstärkende Beschichtung an der Oberseite und Unterseite mit je einer leitfähigen Dünnschicht versehen ist, an die ein elektrisches Potential gelegt ist, wird der gewünschte Elektronenfluß gewährleistet und eine Beschleunigungsspannung über die Schichtdicke der elektronenverstärkenden Beschichtung angelegt.

Wenn benachbarte Pixeloberflächen unterschiedliches Potential aufweisen, kann eine Ladungsbündelung der auf die Sensorfläche auftreffenden Elektronen auf bestimmte, vorausgewählte Pixel erzeugt werden. Eine derarige Ladungsbündelung oder sog. "Binning" kann beispielsweise für eine vorübergehend heruntergeschaltete verringerte Auflösung mit höherem Detektionsgrad verwendet werden.

Wird der Halbleitersensor gemäß Anspruch 9 verwendet, ist ein Bilderfassungssensor angegeben, bei dem Photonen zunächst in einem Vakuumsystem in Elektronen umgewandelt werden und diese Elektronen direkt in ein bildgebendes Spannungssignal (videosignal) umgewandelt werden. Der Halbleitersensor zeigt bei dem erwünschten Beschuß von Elektronen keine Pixeldefekte, so daß eine insgesamt bildorientierte Umwandlung des eingangs auftreffenden optischen Signals in ein elektrisches Signal, z. B. zur Darstellung auf einem Videomonitor, erfolgt.

Bevorzugt wird die Verstärkung in der Bildverstärkerröhre mit einer oder mehreren Multikanalplatten erzeugt. Die Multikanalplatten sorgen für eine Verstärkung der Bildinformation.

Nachfolgend wird ein Ausführungsbeispiel der Erfindung anhand der beiliegenden Zeichnung detailliert beschrieben.

Darin zeigt:
- Fig. 1: in einem Ausschnitt einen schematisierten Quer- schnitt eines erfindungsgemäßen Halbleiter- sensors;
- Fig. 2: ein Schema einer Anordnung zur Bilderfassung mit einem derartigen Halbleitersensor in einem Vakuumsystem mit Photokathode und
- Fig. 3: in einem Ausschnitt einen schmatisierten Querschnitt eines Halbleitersensors in einem weiteren Ausführungsbeispiel.

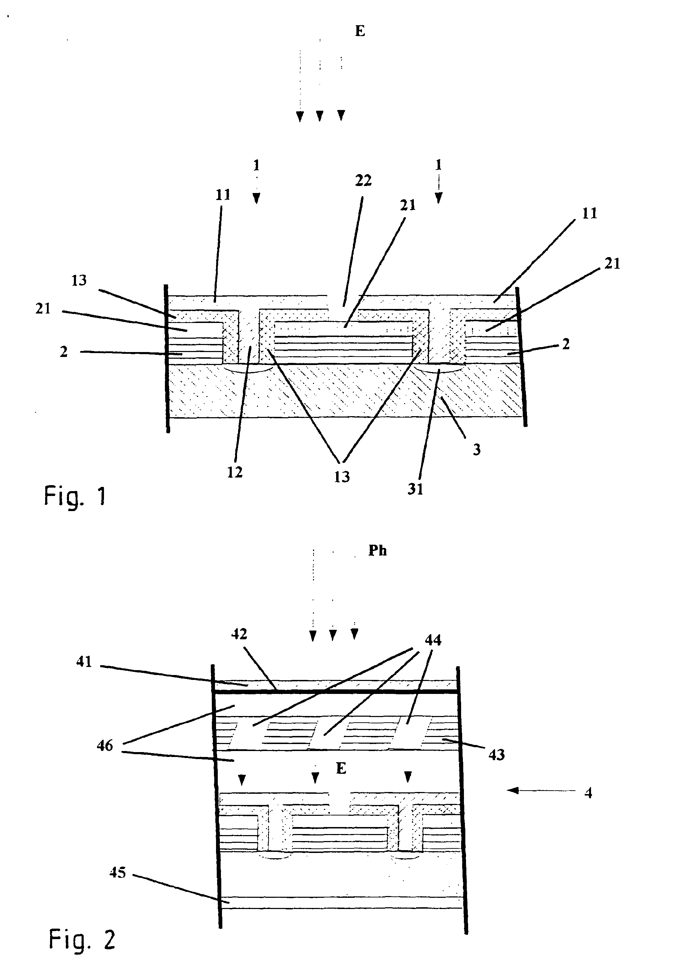

In Fig. 1 ist ein Ausschnitt eines Halbleitersensors mit zwei Pixeln im Querschnitt dargestellt. An der zum zu detektierenden Elektronenstrom gerichteten Oberfläche des Sensors, in Fig. 1 oben, sind der Pixel-struktur 1 zugeordnete leitfähige Schichten als aktive Pixelflächen 11 angeordnet, die bevorzugt aus Aluminium bestehen. Diese leitfähige Schicht 11 ist zu einem Halbleiterelement 3 durchkontaktiert.

Das Halbleiterelement 3 weist ebenfalls eine nicht dargestellte Pixelstruktur 1 auf, die jeder aus einem leitfähigen Material aufgebauten Pixelfläche 11 eine zugeordnete Schaltung nachbildet. Dabei kann das Halbleiterelement 3 als Aktiv-Pixel-Struktur ausgebildet sein. Zwischen der leitfähigen Schicht 11 jedes Pixels und dem Halbleiterelement 3 ist mit Ausnahme der Durchkontaktierung 12 eine Isolierung 13 vorgesehen.

Die Isolierung 13 trennt die zum Halbleiterelement 1 mit Kontaktierung 12 verbundene Sensoroberfläche 11 von einer zweiten leitfähigen Schicht 21, die den Zwischenraum zwischen den Pixelflächen 11 so abschirmt, daß hier auftreffende Elektronen nicht in die darunterliegende Halbleiterstruktur gelangen und dort zu Fehlern führen können. Dabei ist die zweite leitfähige Schicht 21 im dargestellten Ausführungsbeispiel auf einer Passivierungsschicht 2 aufgebracht, die auf der Oberseite des Halbleiterelementes 3 mit Aussparungen für die isolierten Kontaktierungen 12, 13 aufgebracht ist.

Nachfolgend wird die Funktionsweise des Halbleitersensors erläutert.

Der zu detektierende Elektronenstrom E trifft auf die leitfähige Schicht 11 auf. Die jeweils pixelorientiert registrierten Elektronen werden von den aktiven Pixelflächen 11 in Art einer Kondensatorelektrode in das Halbleiterelement 3 zur Konvertierung der Ladung in Spannung geleitet. Je nach Ausbildung des Halbleiters kann die zweite leitfähige Schicht 21 ebenfalls als Kondensatorelektrode verwendet werden. Hier könnte außerdem ein Potential zur Beschleunigung des auftreffenden Elektronenstromes E angelegt werden. Die leitfähige Schicht 11 jedes Pixels ist als Zuleitung (Elektrode) zu einem "floating diffusion" 31 oder "floating gate" zur Ladungskonvertierung ausgebildet.

In Fig. 2 ist eine bevorzugte Kombination des Halbleitersensors ähnlich der Ausgestaltung gemäß Fig. 1 in einem Vakuumsystem 4 in schematisiertem Querschnitt im Ausschnitt dargestellt. Das Vakuumsystem 4 besitzt ein Eingangsfenster 41 mit einer Photokathode 42. Im Vakuumbereich 46 des Bausteins 4 ist wenigstens eine Multikanalplatte 43 mit einer Vielzahl von Kanälen 44 vorgesehen.

Im Gegensatz zu herkömmlichen Bildwandlern- bzw. Bildverstärkerröhren ist am Ausgangsfenster 45 kein Leuchtschirm zur Umwandlung des Elektronenstromes E in sichtbares Licht vorgesehen, sondern direkt innerhalb des Vakuumsystems der Halbleitersensor gemäß Ausgestaltung nach Fig. 1 angeordnet. Dabei ist die Pixelstruktur 1 so ausgerichtet, daß die Signalinformation aus den Kanälen 44 der Multikanalplatte 43 auf die leitfähigen Schichten 11 der Pixel treffen. Somit ist eine bildorientierte Verarbeitung der an der Photokathode 42 aufgenommenen Bildinformationen möglich. Das Ausgangsfenster 45 ist als Abschlußelement für den Vakuumbereich 46 an der Rückseite des Halbleiterelementes 3 angeordnet. Im Abschlußelement 45 kann die Kontaktierung der Halbleiterstruktur nach außen geführt werden.

Nachfolgend wird die Funktionsweise der Bilderfassungsanordnung erläutert:

Optische Bildinformationen gelangen in Form eines Photonenstromes Ph durch das Eingangsfenster 41 auf die Photokathode 42 des Vakuumsystems (VA-MOS) 4. Dort werden mit den auftreffenden Photonen Ph Elektronen aus dem Photokathodenmaterial herausgelöst. Zur Verstärkung des von der Photokathode ausgelösten Elektronenstromes E werden die Elektronen durch ein an der Multikanalplatte 43 angelegtes elektrisches Feld beschleunigt. Die so entstehende Elektronenstrahlung E gelangt über die Kanäle 44 der Multikanalplatte 43 auf die Pixelflächen 11 des Halbleitersensors mit seiner Pixelstruktur 1. Unterhalb des Halbleiters wird der Vakuumbereich 46 des Systems 4 mit einem Abschlußelement 45 abgeschlossen, das beispielsweise als Keramikscheibe mit Kontaktierungsdurchführungen für den Halbleitersensor ausgebildet ist.

Die Funktionsweise des Halbleitersensors entspricht dem zum Ausführungsbeispiel gemäß Fig. 1 Beschriebenen. Dabei wird die Elektronenstrahlung E von dem Halbleitersensor direkt in ein elektrisches Signal umgewandelt. Mit dieser Struktur kann somit ein empfangenes Bild in einer nachgeschalteten Signalverarbeitung auf dem Halbleiterelement oder extern, beispielsweise in ein Videosignal, gewandelt werden.

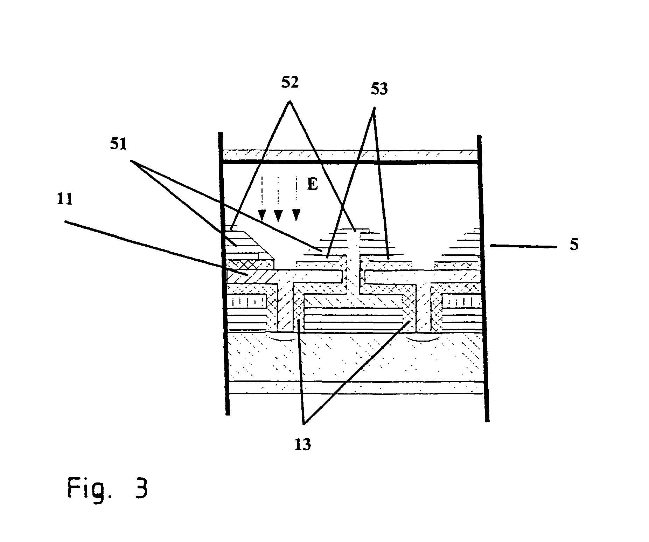

In Fig. 3 ist ein Halbleitersensor gemäß Fig. 1 dargestellt, auf dessen Sensoroberfläche eine elektronenverstärkende Beschichtung 5 vorgesehen ist. Die Beschichtung 5 besteht im wesentlichen aus einem elektronenverstärkendem Material 51, beispielsweise Alpha-Silizium. Um eine entsprechende Elektronenverstärkung in diesem Material hervorzurufen, weist die Beschichtung 5 eine obere und untere Dünnschicht 52, 53 auf, die aus leitfähigem Material bestehen. An die Dünnschichten 52, 53 ist ein geeignetes elektrisches Potential gelegt. An der Kontaktfläche der unteren Dünnschicht 53 zur Pixeloberfläche 11 ist eine Isolierung vorgesehen, beispielsweise die Isolierung 13. Um die Elektronen zu den Pixeloberflächen 11 zu leiten sind Durchgangskanäle 54 in der Beschichtung 5 vorgesehen. Diese Durchgangskanäle 54 sind bevorzugt pixelorientiert angeordnet.

Dabei ist hervorzuheben, daß der erfindungsgemäße Halbleitersensor einen Elektronenstrom E direkt ohne Zwischenwandlung in Lichtsignale pixelorientiert in ein elektrisches Signal wandeln kann. Dabei besteht nicht die Gefahr von Pixeldefekten, wie bei herkömmlichen Bildsensoren.

### Bezugszeichenliste

- 1: Pixelstruktur
- 11: Pixeloberfläche; leitfähige Schicht
- 12: Kontakierung
- 13: Isolierung

- 2: Passivierungsschicht
- 21: zweite leitfähige Schicht
- 22: Zwischenraum

- 3: Halbleiterelement
- 31: floating diffusion

- 4: Vakuumröhre
- 41: Eingangsfenster
- 42: Photokathode
- 43: Multi-Kanal-Platte (MCP)
- 44: Kanal
- 45: Ausgangsfenster oder Abschlußelement
- 46: Vakuumbereich

- 5: elektronenverstärkende Beschichtung
- 51: elektronenverstärkendes Material (Alpha-Silizium)
- 52: obere Dünnschicht
- 53: untere Dünnschicht
- 54: Durchgangskanal

- E: Elektronen
- Ph: Photonen

## Patentansprüche

1. Halbleitersensor mit einer Pixelstruktur (1), wobei zu jedem Pixel eine Kapazität ausgebildet ist, die Ladung speichert und in Spannung konvertiert, die bedarfsweise auslesbar ist, und die Pixel-struktur (1) im wesentlichen vollständig mit einer leitfähigen Schicht, der Pixeloberflächenbeschichtung (11) abgedeckt ist, **dadurch gekennzeichnet, daß** der Sensor zum unmittelbaren Detektieren von Elektronen ausgebildet ist und zwischen den Pixeloberflächenbeschichtungen (11) jedes einzelnen Pixels Zwischenräume (22) ausgebildet sind, wobei die Oberfläche der Zwischenräume (22) zwischen den Pixeln mit einer zweiten leitfähigen Schicht (21), die isoliert von den Pixeloberflächenbeschichtungen (11) angeordnet ist, abgedeckt ist.

2. Halbleitersensor nach Anspruch 1, **dadurch gekennzeichnet, daß** die Pixeloberflächenbeschichtungen (11) und die zweite leitfähige Schicht (21) aus Metall oder einem leitfähigen, lichtundurchlässigen Material bestehen.

3. Halbleitersensor nach Anspruch 2, **dadurch gekennzeichnet, daß** die Pixeloberflächenbeschichtungen (11) und die zweite leitfähige Schicht (21) aus Aluminium bestehen.

4. Halbleitersensor nach Anspruch 1, 2 oder 3, **dadurch gekennzeichnet, daß** die zweite leitfähige Schicht (21) als Kondensatorelektrode ausgebildet ist.

5. Halbleitersensor nach Anspruch 1, 2, 3 oder 4, **dadurch gekennzeichnet, daß** an der zweiten leitfähigen Schicht (21) ein Potential angelegt werden kann.

6. Halbleitersensor nach einem der vorangehenden Ansprüche, **dadurch gekennzeichnet, daß** die Detektionsoberfläche des Sensors mit einer elektronenverstärkenden Beschichtung (5) versehen ist, wobei Durchgangskanäle (54) zu den Pixeloberflächen (11) vorgesehen sind.

7. Halbleitersensor nach Anspruch 6, **dadurch gekennzeichnet, daß** die elektronenverstärkende Beschichtung (5) an der Oberseite und Unterseite mit je einer leitfähigen Dünnschicht (52, 53) versehen ist, an die ein elektrisches Potential gelegt werden kann.

8. Halbleitersensor nach einem der vorangehenden Ansprüche, **dadurch gekennzeichnet, daß** benachbarte Pixeloberflächen (11) unterschiedliches Potential aufweisen können.

9. Verwendung eines Halbleitersensors nach einem der vorangehenden Ansprüche angeordnet in einem Vakuumsystem mit Photokathode, welche bildorientiert Photonen in Elektronen umwandelt.

10. Verwendung nach Anspruch 9, wobei das Vakuumsystem eine oder mehrere Multikanalplatten (multi-channel-plate) zur Verstärkung des Elektronenstroms aufweist.

## Claims

1. Semiconductor sensor comprising a pixel structure (1), wherein for each pixel a capacitance is formed which stores charge and converts it into voltage which can be read out as required, and the pixel structure (1) is covered substantially completely with a conductive layer, the pixel surface coating (11), **characterized in that** the sensor is designed for directly detecting electrons and interspaces (22) are formed between the pixel surface coatings (11) of each individual pixel, wherein the surface of the interspaces (22) between the pixels is covered with a second conductive layer (21), which is arranged in a manner insulated from the pixel surface coatings (11).

2. Semiconductor sensor according to Claim 1, **characterized in that** the pixel surface coatings (11) and the second conductive layer (21) are composed of metal or a conductive, light-opaque material.

3. Semiconductor sensor according to Claim 2, **characterized in that** the pixel surface coatings (11) and the second conductive layer (21) are composed of aluminium.

4. Semiconductor sensor according to Claim 1, 2 or 3, **characterized in that** the second conductive layer (21) is formed as a capacitor electrode.

5. Semiconductor sensor according to Claim 1, 2, 3 or 4, **characterized in that** a potential can be applied to the second conductive layer (21).

6. Semiconductor sensor according to any of the preceding claims, **characterized in that** the detection surface of the sensor is provided with an electron-amplifying coating (5), wherein passage channels (54) to the pixel surfaces (11) are provided.

7. Semiconductor sensor according to Claim 6, **characterized in that** the electron-amplifying coating (5), on the top side and underside, is provided with a respective conductive thin layer (52, 53), to which an electrical potential can be applied.

8. Semiconductor sensor according to any of the preceding claims, **characterized in that** adjacent pixel surfaces (11) can have a different potential.

9. Use of a semiconductor sensor according to any of the preceding claims arranged in a vacuum system with a photocathode which converts photons into electrons in an image-oriented manner.

10. Use according to Claim 9, wherein the vacuum system has one or a plurality of multi-channel plates for amplifying the electron current.

## Revendications

1. Capteur à semiconducteur comprenant une structure en pixels (1), une capacité étant formée pour chaque pixel, laquelle accumule une charge et la convertit en tension qui peut être relevée en cas de besoin, et la structure en pixels (1) est pour l'essentiel entièrement recouverte d'une couche conductrice, le revêtement de surface des pixels (11), **caractérisé en ce que** le capteur est configuré pour la détection immédiate d'électrons et des espaces intermédiaires (22) sont formés entre les revêtements de surface des pixels (11) et chaque pixel individuel, la surface des espaces intermédiaires (22) entre les pixels étant recouverte par une deuxième couche conductrice (21) qui est disposée de manière isolée par rapport aux revêtements de surface des pixels (11).

2. Capteur à semiconducteur selon la revendication 1, **caractérisé en ce que** les revêtements de surface des pixels (11) et la deuxième couche conductrice (21) sont constitués de métal ou d'un matériau conducteur opaque,

3. Capteur à semiconducteur selon la revendication 2, **caractérisé en ce que** les revêtements de surface des pixels (11) et la deuxième couche conductrice (21) sont en aluminium.

4. Capteur à semiconducteur selon la revendication 1, 2 ou 3, **caractérisé en ce que** la deuxième couche conductrice (21) est réalisée sous la forme d'une électrode de condensateur.

5. Capteur à semiconducteur selon la revendication 1, 2, 3 ou 4, **caractérisé en ce qu'**un potentiel peut être appliqué à la deuxième couche conductrice (21).

6. Capteur à semiconducteur selon l'une des revendications précédentes, **caractérisé en ce que** la surface de détection du capteur est munie d'un revêtement amplificateur d'électrons (5), des canaux de passage (54) vers les surfaces des pixels (11) étant prévus.

7. Capteur à semiconducteur selon la revendication 6, **caractérisé en ce que** le revêtement amplificateur d'électrons (5) est muni sur le côté supérieur et le côté inférieur à chaque fois d'une couche mince conductrice (52, 53) à laquelle peut être appliqué un potentiel électrique.

8. Capteur à semiconducteur selon l'une des revendications précédentes, **caractérisé en ce que** les surfaces de pixel voisines (11) peuvent présenter des potentiels différents.

9. Application d'un capteur à semiconducteur selon l'une des revendications précédentes, disposé dans un système sous vide avec une photocathode qui convertit en électrons des photons destinés à former une image.

10. Application selon la revendication 9, le système sous vide présentant une ou plusieurs plaques à canaux multiples (multi-channel-plate) pour amplifier le courant d'électrons.
